Europäisches Patentamt

European Patent Office

Office européen des brevets

(11) Publication number: **0 076 160**
**B1**

(12) **EUROPEAN PATENT SPECIFICATION**

(45) Date of publication of patent specification: **16.04.86**

(51) Int. Cl.⁴: **H 03 K 19/195**

(21) Application number: **82305157.8**

(22) Date of filing: **29.09.82**

(54) Josephson-junction logic device.

(30) Priority: **30.09.81 JP 153886/81**

(43) Date of publication of application:
**06.04.83 Bulletin 83/14**

(45) Publication of the grant of the patent:
**16.04.86 Bulletin 86/16**

(84) Designated Contracting States:
**DE FR GB**

(56) References cited:
**IBM TECHNICAL DISCLOSURE BULLETIN, vol.
18, no. 11, April 1976, pages 3894-3896, New
York, US B.S. LANDMAN et al.: "Wide-margin
nonlatching josephson logic family"**

(73) Proprietor: **FUJITSU LIMITED**
**1015, Kamikodanaka Nakahara-ku**
**Kawasaki-shi Kanagawa 211 (JP)**

(72) Inventor: **Suzuki, Hideo**
**5-28-9, Tsunashima Higashi Kohoku-ku**
**Yokohama-shi Kanagawa 223 (JP)**

(74) Representative: **Opperman, Stuart Richard et al**
**Haseltine Lake & Co. Hazlitt House**
**28 Southampton Buildings Chancery Lane**
**London WC2A 1AT (GB)**

Courier Press, Leamington Spa, England.

## Description

The present invention relates to a Josephson-junction logic device. A Josephson-junction logic gate can be based on three or more Superconducting Quantum Interference Devices (SQUIDs) of a magnetically-coupled gate type. Conventional Josephson logic gates consisting of multi-junction SQUIDs can be divided into two types, namely a type with a magnetically coupled gate having magnetically coupled control lines as disclosed in U.S. Patent 3,978,351 and a type with a current-injection gate in which the input current is allowed to flow directly into a loop of the SQUID as disclosed in U.S. Patent 4,117,354.

In the magnetically coupled-type gate, an input current is fed to the magnetically coupled control lines, i.e. the input signal lines, to change the magnetic field coupled with the loop of the SQUID, whereby the critical current of the gate is changed and a superconductive state is switched to a voltage state. In the conventional magnetically coupled gate, however, the input signal lines are arranged so as to be adjacent to the total inductance of the superconducting loop. In this construction, the critical current is simply determined by the sum of the input currents supplied to the input signal lines. That is, the critical current is linearly changed with respect to the sum of the input currents. Because of the linear characteristics, there is a disadvantage in that the allowable ranges of the input currents are small, and, therefore, the margin for operation is small.

The current injection-type gate, in which input current is allowed to flow directly into the loop of the gate, utilizes a phenomenon in which a superconductive state is switched to a voltage state when the input current exceeds a threshold value. In the current injection-type gate, the critical current is not determined simply by the sum of the input currents. Therefore, the current injection-type gate has nonlinear threshold characteristics, and its boundary between a superconductive state and a voltage state changes more rapidly than that of the magnetically coupled gate, making it possible to improve the operation margin as compared with the operation margin of the magnetically coupled-type gate. This type of gate, however, requires magnetically coupled circuits for electrically isolating the inputs from the output. Because the magnetically coupled circuits are a necessity, there are disadvantages in the current injection-type gate in that the gate is a large-scale device and in that the cost is high.

It is, therefore, desirable to increase the allowable range of the input currents of a Josephson-junction logic device of a magnetically-coupled type, including three or more Josephson-junctions thereby avoiding any need to resort to the use of a magnetically coupled circuit for electrically isolating the inputs from the output.

According to the present invention there is provided a Josephson-junction logic device comprising:

a first superconductive loop, having a first Josephson-junction element and a second Josephson-junction element and a first inductance connected between the said first Josephson-junction element and the said second Josephson-junction element;

a second superconductive loop, having the said second Josephson-junction element and a third Josephson-junction element and a second inductance connected between the said second Josephson-junction element and the said third Josephson-junction element;

first and second logic input signal lines; and output terminals, connected for providing a logic output signal from across one of the said Josephson-junction elements when the device is in use;

characterised in that the said first logic input signal line includes a third inductance arranged adjacent to the said first inductance so that magnetic coupling occurs between the third and first inductances but substantially no such coupling occurs between the third and second inductances, when the device is in use, and the said second logic input signal line includes a fourth inductance arranged adjacent to the said second inductance so that magnetic coupling occurs between the fourth and second inductances but substantially no such coupling occurs between the fourth and first inductances when the device is in use.

In an embodiment of the present invention, a nonlinear relationship exists between input currents which determine the critical current for switching.

Reference will now be made, by way of example, to the accompanying drawings, in which:—

Figure 1A is a circuit diagram illustrating an example of a conventional Josephson-junction logic AND gate of a magnetically coupled type including three Josephson junctions;

Figure 1B is a graph illustrating the relationship between the input current and the bias current with respect to the critical current of the gate of Figure 1A;

Figure 1C is a graph illustrating the relationship among the input currents determining the critical current when the bias current is constant in the gate of Figure 1A;

Figure 2A is a circuit diagram illustrating a Josephson-junction logic AND gate according to a first embodiment of the present invention;

Figure 2B is a graph illustrating the relationship between the input current and the bias current with respect to the critical current of the gate of Figure 2A;

Figure 2C is a plan view illustrating the physical structure of the gate of Figure 2A;

Figure 3A is a circuit diagram illustrating a Josephson-junction logic AND gate according to a second embodiment of the present invention;

Figure 3B is a plan view illustrating the physical structure of the gate of Figure 3A;

Figure 3C is a graph illustrating the relationship between the input current and the bias current with respect to the critical current of the gate of Figure 3A;

Figure 3D is a graph illustrating the relationship among the input currents determining the critical current when the bias current is constant in the circuit of Figure 3A;

Figure 4 is a circuit diagram illustrating a Josephson-junction logic AND gate according to a third embodiment of the present invention; and

Figure 5 is a circuit diagram illustrating a Josephson-junction logic gate according to a fourth embodiment of the present invention.

Now, an embodiment of the present invention will be described in comparison with a conventional example, with reference to the drawings.

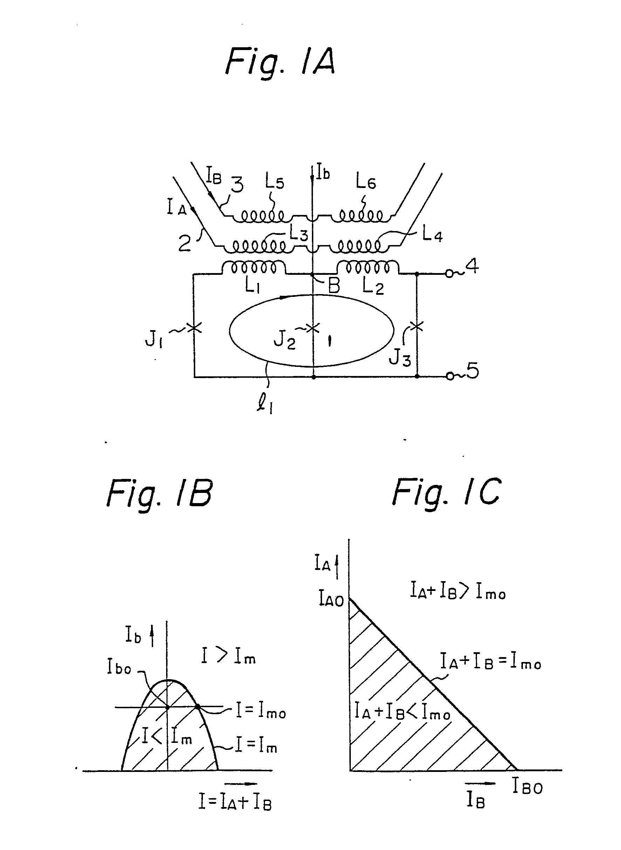

Figure 1A illustrates a conventional example of a magnetically coupled-type logic AND gate including three Josephson-junction elements hereinafter referred to as Josephson-junctions. In Figure 1A, the logic AND gate comprises three Josephson-junctions $J_1$, $J_2$, and $J_3$, an inductance $L_1$ between the junctions $J_1$ and $J_2$, an inductance $L_2$ between the junctions $J_2$ and $J_3$, and inductances $L_3$, $L_4$, $L_5$, and $L_6$ which are arranged so as to be opposite to all of the inductances $L_1$ and $L_2$ and are able to magnetically couple with them. The inductances $L_1$ and $L_2$ and the Josephson-junctions $J_1$ and $J_3$ constitute a superconductive loop $l_1$. At a node B between the inductances $L_1$ and $L_2$ in the loop $l_1$, a bias current $I_b$ is supplied. Input currents $I_A$ and $I_B$ are supplied to input signal lines 2 and 3 which include the inductances $L_3$ and $L_4$ and $L_5$ and $L_6$, respectively. When the input currents $I_A$ and $I_B$ are supplied, the inductances $L_3$ and $L_4$ and $L_5$ and $L_6$ produce a magnetic field. Then the superconductive loop $l_1$ is magnetically coupled to the produced magnetic field so that the critical current $I_m$ between a superconductive state and a voltage state of the logic AND gate is changed.

Figure 1B is a graph showing the relationship between the sum of the input currents $I=I_A+I_B$ and the bias current $I_b$ with respect to the critical current $I_m$ of the superconductive loop $l_1$ in the circuit of Figure 1. In Figure 1B, when the sum of the input currents $I_A+I_B$ is smaller than the critical current $I_m$, indicated by the hatched areas, the AND gate of Figure 1A is in a superconductive state so that no voltage appears across the output terminals 4 and 5. When the sum of the input currents $I_A+I_B$ is greater than the critical current $I_m$, the gate assumes a voltage state so that a voltage appears across the output terminals 4 and 5. When the bias current $I_b$ is kept constant at $I_{b0}$, the critical current is fixed at $I_{m0}$.

Figure 1C is a graph illustrating the relationship between the input currents $I_A$ and $I_B$ which determine the critical current $I_{m0}$ in the circuit of Figure 1A under a condition in which the bias current $I_b$ is kept constant at $I_{b0}$, and, accordingly, the critical current is fixed at $I_{m0}$. In Figure 1C, when the sum of the input currents $I_A$ and $I_B$ is smaller than the constant critical current $I_{m0}$, indicated by the hatched areas, the AND gate of Figure 1A is in a superconductive state. When $I_A+I_B$ is greater than $I_{m0}$, the AND gate is in a voltage state. Because the critical current $I_{m0}$ is constant, the characteristic of the relationship between the input currents $I_A$ and $I_B$, which determine the critical current $I_{m0}$, is a linear one. Due to this fact, the allowable range of the input currents to maintain the gate in a superconductive state is narrow, as will be explained in detail later in comparison with the embodiments of the present invention. For example, when $I_B=0$, the gate is switched from a superconductive state to a voltage state when the input current $I_A$ increases over $I_{A0}=I_{m0}$. Also, when $I_A=0$, the gate is switched to a voltage state when the input current $I_B$ increases over $I_{B0}=I_{m0}$. The input current $I_{A0}$ or $I_{B0}$ is so small that the gate is easily switched to a voltage state. This is the reason why the conventional AND gate has a disadvantage of a narrow allowable range with respect to the input currents.

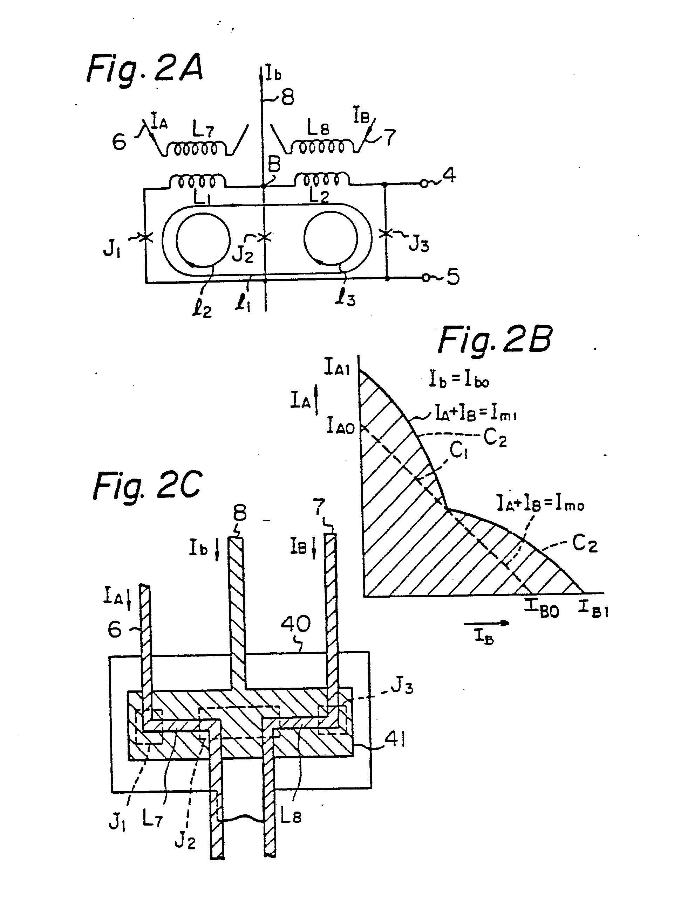

The first embodiment of the present invention will now be described with reference to Figures 2A through 2C.

In Figures 2A, the same portions as those in the circuit of Figure 1A are denoted by the same reference symbols. Figure 2A is also a circuit diagram of a Josephson-junction logic AND gate. The difference between Figure 1A and Figure 2A is that, in place of the inductances $L_3$ through $L_6$ which are arranged opposite to all of the inductances $L_1$ and $L_2$ in the loop $l_1$, in Figure 2A, the inductances $L_7$ and $L_8$ are separately arranged so as to be opposite to the inductance $L_1$ and the inductance $L_2$, respectively. By this arrangement, the inductance $L_7$ can be magnetically coupled to only the inductance $L_1$, and the inductance $L_8$ can be magnetically coupled to only the inductance $L_2$. The inductances $L_7$ and $L_8$ are magnetically independent from the inductances $L_2$ and $L_1$, respectively. The inductance $L_1$ and the two Josephson junctions $J_1$ and $J_2$ constitute a superconductive loop $l_2$. The inductance $L_2$ and the two Josephson junctions $J_2$ and $J_3$ constitute another superconductive loop $l_3$. An input current $I_A$ is supplied to an input signal line 6 including the inductance $L_7$. An input current $I_B$ is supplied to an input signal line 7 including the inductance $L_8$. When the inductances $L_1$ and $L_2$ are magnetically coupled with the inductances $L_7$ and $L_8$, respectively, the critical current $I_m$ of the gate of Figure 2A varies.

Assume that the Josephson junctions $J_1$, $J_2$, and $J_3$ are identical, the inductances $L_1$, $L_2$, $L_7$ and $L_8$ are identical, and the bias current $I_b$ is fixed at a constant value $I_{b0}$ as in Figure 1A. Then the critical current $I_{m1}$ is not constant as in the conventional gate but varies depending on the input current $I_A$ or $I_B$. Therefore, as illustrated in Figure 2B by the solid curve $C_2$, the characteristic of the relationship between the input currents $I_A$ and $I_B$, which determine the critical current $I_{m1}$, is a nonlinear

one. In Figure 2B, when $I_A+I_B\leqq I_{m1}$, as shown by the hatched area, the gate of Figure 2A is in a superconductive state, and when $I_A+I_B>I_{m1}$, the gate is in a voltage state. Thus, the circuit of Figure 2A works as an AND gate. The dashed line $C_1$ in Figure 2B shows the conventional graph of Figure 1C. As will be apparent from Figure 2B, in order to switch the gate to the voltage state by supplying a single current $I_A$ or $I_B$, the current $I_A$ or $I_B$ must be greater than $I_{A1}$ or $I_{B1}$, $I_{A1}$ and $I_{B1}$ being greater than the conventional current $I_{A0}$ and $I_{B0}$, respectively. In other words, when $I_B=0$, the allowable range of the input current $I_A$ to maintain the gate in a superconductive state is increased by $I_{A1}-I_{A0}$ as compared with the conventional gate of Figure 1A. Also, when $I_A=0$, the allowable range of the input current $I_B$ to maintain the gate in a superconductive state is increased by $I_{B1}-I_{B0}$ as compared with the conventional gate.

The reason why the allowable range of the input currents is expanded is as follows. That is, in Figure 2A, because the inductance $L_7$ is arranged so as to be opposite to only the inductance $L_1$ included in the loop $I_1$, the inductance $L_7$ can be magnetically coupled with only the inductance $L_1$ and is not magnetically coupled with the inductance $L_2$. When the inductance $L_1$ is magnetically coupled with the inductance $L_7$, the phase difference $\phi_{L1}$ across the inductance $L_1$ is changed. In order to satisfy a quantum condition in the loop $I_2$:

$$\phi_{L1}+\phi_{J1}+\phi_{J2}=2n\pi$$

where $\phi_{J1}$ and $\phi_{J2}$ are phase differences across the Josephson junctions $J_1$ and $J_2$ and n is a positive integer, the phase differences $\phi_{J1}$ and $\phi_{J2}$ are changed. Next, in order to satisfy a quantum condition in the loop $I_3$, the phase differences $\phi_{J3}$ and $\phi_{L2}$ of the Josephson junction $J_3$ and the inductance $L_2$ are changed. Thus, the inductance $L_2$ and the Josephson junction $J_3$ are indirectly influenced by the input current $I_A$. Due to this indirect influence, a large input current must be supplied to the input signal line 6 for switching the gate from a superconductive state to a voltage state. Similarly, because the inductance $L_8$ is arranged opposite to only the inductance $L_2$, a large input current must be supplied to the input signal line 7 for switching the gate. The threshold characteristic is not restricted to the embodiment of Figure 2B. By selecting an appropriate value of the critical current of each Josephson junction $J_1$, $J_2$, or $J_3$ of the inductance $L_1$, $L_2$, $L_7$, or $L_8$ or of the bias current $I_b$, any desired nonlinear threshold characteristic can be obtained.

Figure 2C is a plan view of the physical structure of the circuit of Figure 2A. In Figure 2C, on a base electrode 40, a counter electrode 41 is formed through an insulating film (not shown). The base electrode 40 and the counter electrode 41 are each composed of a thin superconductive film made of, for example, a lead alloy or the like. The Josephson junctions $J_1$, $J_2$ and $J_3$ are formed by the base electrode 40, the counter electrode 41, and a thin insulating film (not shown) capable of causing super-conducting tunneling. The counter electrode 41 is connected to a bias line 8. The input signal line 6 extends so that its inductance $L_7$ is opposite to the inductance $L_1$ of a part of the counter electrode 41 between the Josephson junctions $J_1$ and $J_2$. Similarly, the input signal line 7 extends so that its inductance $L_8$ is opposite to the inductance $L_2$ of another part of the counter electrode 41 between the Josephson junctions $J_2$ and $J_3$. By this arrangement, the inductance $L_7$ is not magnetically coupled directly with the inductance $L_2$, and the inductance $L_8$ is not magnetically coupled directly with the inductance $L_1$. Therefore, the allowable range of the input currents is increased.

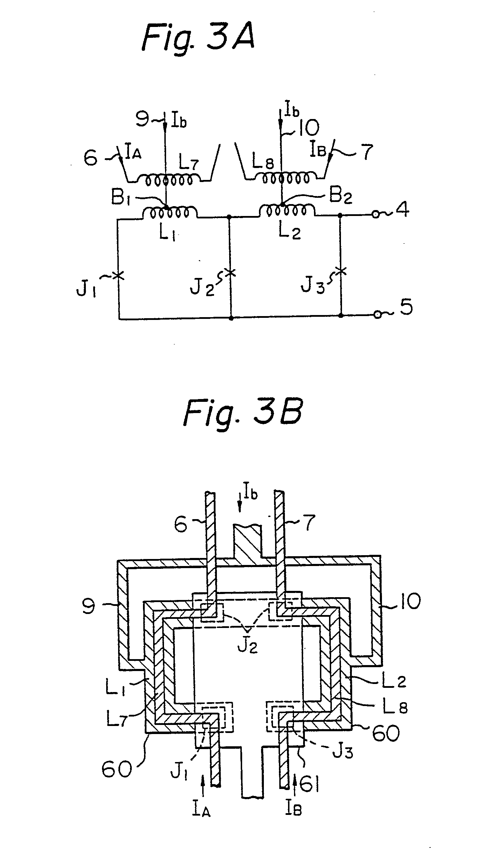

The second embodiment of the present invention will now be described with reference to Figures 3A through 3D.

Figure 3A is a circuit diagram of a Josephson logic AND gate according to the second embodiment of the present invention. The difference between the gates of Figure 2A and Figure 3A is that, in Figure 2A, the single bias line 8 is connected to a point B between the inductances $L_1$ and $L_2$ and, in contrast, in Figure 3A, two bias lines 9 and 10 are connected to the middle points $B_1$ and $B_2$ of the inductances $L_1$ and $L_2$ respectively.

Figure 3B is a plan view of the physical structure of the gate of Figure 3A. In Figure 3B, 60 is a base electrode made of lead alloy or the like, and 61 is a counter electrode of superconductive material formed on a part of the base electrode 60 through an insulating film (not shown). The Josephson junctions $J_1$, $J_2$ and $J_3$ are formed at the portions where the insulating film between the base electrode 60 and the counter electrode 61 are so thin that super-conducting tunneling is caused therethrough. The part of the base electrode 60 extending on both sides of the counter electrode 61 constitutes the inductances $L_1$ and $L_2$. The bias lines 9 and 10 are connected to the middle portions of the inductances $L_1$ and $L_2$. The input signal lines 6 and 7 extend so that their inductances $L_7$ and $L_8$ are opposite to and are able to magnetically couple with the inductances $L_1$ and $L_2$. As will be apparent from Figure 3B, since the inductance $L_7$ is separated from the inductance $L_2$, the inductance $L_7$ is not magnetically coupled directly to the inductance $L_2$. Similarly, the inductance $L_6$ is not magnetically coupled directly to the inductance $L_1$. As a result, the allowable range of the input currents for keeping the gate in a superconductive state is also increased as compared with the conventional example.

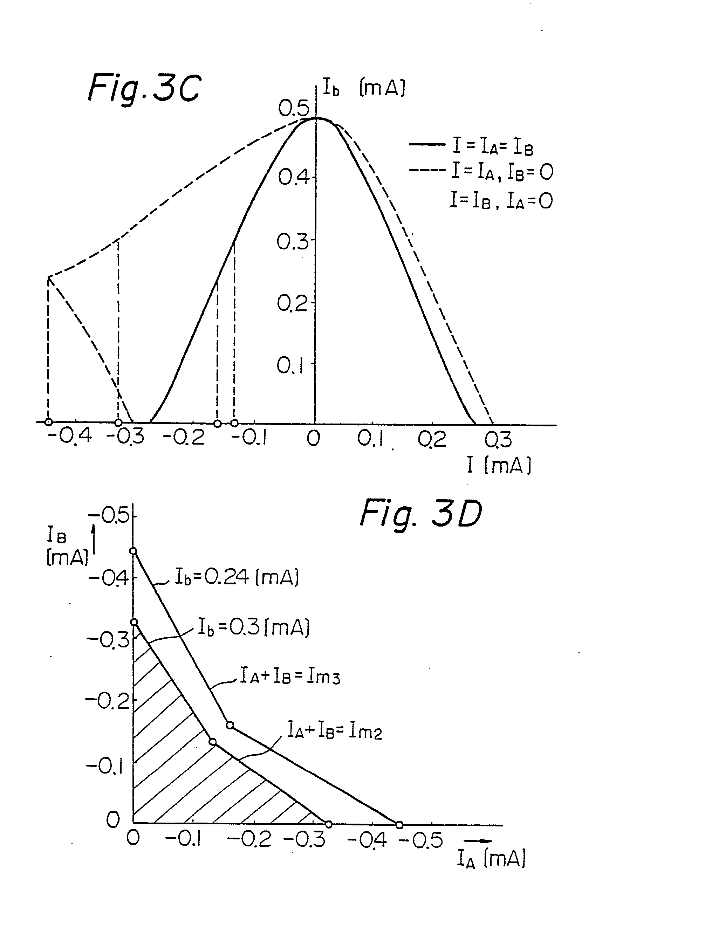

Figure 3C is a theoretical graph illustrating the relationship between the input current and the bias current with respect to the critical current of the gate of Figure 3A. Assume that the critical current of the Josephson junction $J_1$ or $J_3$ in Figure 3A is $I_0=0.125$ mA, the inductances $L_1$, $L_2$, $L_7$ and $L_8$ are each 4.14 pH, and the critical current of the Josephson junction $J_2$ in Figure 3A is

$2I_0 = 0.250$ mA. In Figure 3C, the abscissa represents the input current $I = I_A$ or $I_B$, and the ordinate represents the bias current $I_b$. The solid curve represents the threshold characteristic when the input current $I_A$ supplied to the input signal line 6 is equal to the input current $I_B$ supplied to the input signal line 7. The dashed curve represents the threshold characteristic when one of the input currents $I_A$ and $I_B$ is zero. Different from the conventional threshold characteristic of Figure 1B, the threshold characteristic of Figure 3C depends on the ratio of the input currents $I_A$ and $I_B$. Therefore, even when the bias current $I_b$ is fixed at a constant value, the critical input current for switching the gate of Figure 3A from a superconductive state to a voltage state is not constant. For example, when the bias current $I_b$ is 0.3 mA, the critical current $I$ is about $-0.13$ mA when the input current $I_A$ is equal to $I_B$, as can be seen from the solid curve, and the critical current $I$ is about $-0.325$ mA when one of the input currents $I_A$ and $I_B$ is zero, as can be seen from the dashed curve. Therefore, when the bias current $I_b$ is fixed at, for example, 0.3 mA, the critical input current $I$ varies from about $-0.13$ mA to about $-0.325$ mA. The negative input current has a direction opposite to the direction of the arrows in Figure 3A.

Figure 3D is a graph illustrating the relationship between the input currents $I_A$ and $I_B$ which determine the critical current of the AND gate of Figure 3A. The abscissa represents the input current $I_A$, and the ordinate represents the input current $I_B$. In Figure 3D, two threshold curves are illustrated, i.e., the curve when the bias current $I_b$ is 0.3 mA and the curve when the bias current $I_b$ is 0.24 mA. For the purpose of simplicity, these curves are illustrated by straight lines. In practice, however, these curves are similar to the curve of Figure 2B. It can be confirmed that, in Figures 3C and 3D, when the bias current $I_b$ is 0.3 mA, the critical input current $I_A$ or $I_B$ is about $-0.325$ mA when one of the input currents is zero, and the critical input current is about $-0.13$ mA when both input currents are equal. When the input currents $I_A$ and $I_B$ are changed, a threshold curve represented by the expression $I_A + I_B = I_{m2}$ is obtained. It should be noted that the critical current $I_{m2}$ is not constant as in the conventional graph of Figure 1C but varies depending on the ratio of the input currents $I_A$ and $I_B$. Therefore, the threshold curve of Figure 3D shows a nonlinear characteristic. When $I_A + I_B < I_{m2}$ as in the hatched area, the AND gate of Figure 2C is in a superconductive state. When $I_A + I_B > I_{m2}$, the AND gate is in a voltage state.

With respect to the curve expressed by $I_A + I_B = I_{m3}$ in Figure 3D, which is the threshold curve when the bias current $I_b$ is 0.24 mA, it can also be confirmed that, in Figures 3C and 3D, when one of the input currents is zero, the critical current $I_A$ or $I_B$ is about $-0.44$ mA, and when both input currents are equal, the critical current is about $-0.16$ mA.

It will be apparent that, according to the second embodiment also, the allowable range of the input signal for maintaining the gate in a superconductive state is increased as compared with the conventional gate having a linear characteristic.

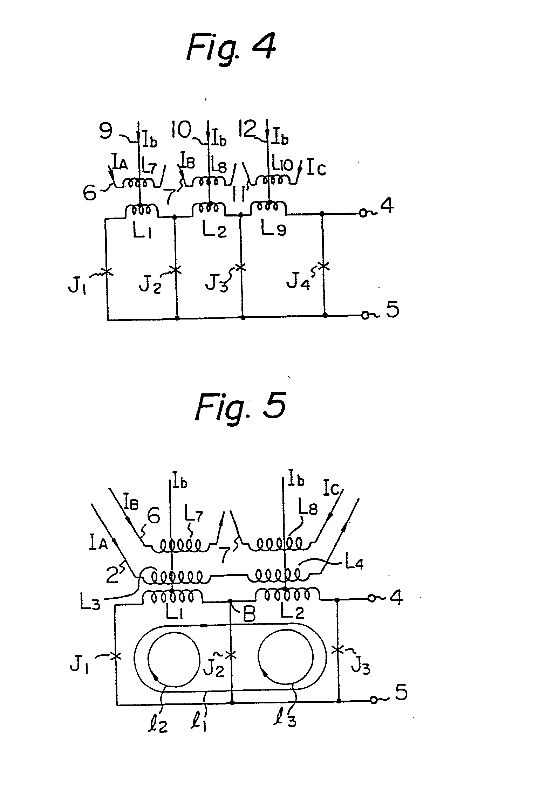

Figure 4 illustrates a circuit diagram of a three-input Josephson junction logic AND gate according to a third embodiment of the present invention. The difference between Figure 3A and Figure 4 is that, in Figure 4, there are provided an additional Josephson junction $J_4$ connected between the output terminals 4 and 5, an additional inductance $L_9$ connected between the junctions $J_3$ and $J_4$, an additional inductance $L_{10}$ arranged opposite to the inductance $L_9$, and an additional bias line 11 connected to the middle portion of the inductance $L_9$. By this circuit configuration, a three-input Josephson-junction logic AND gate having a wide allowable range of input currents for maintaining the gate in a superconductive state can be obtained in a manner similar to that in the embodiment of Figure 3A.

Figure 5 illustrates a fourth embodiment of the present invention. The difference between Figure 3A and Figure 5 is that, in Figure 5, an additional input signal line 2 is provided. The input line 2 in Figure 5 is similar to that in the conventional circuit of Figure 1A and has the inductances $L_3$ and $L_4$. The input line 2 extends between the inductances $L_1$ and $L_7$ and between the inductances $L_2$ and $L_8$ so that the inductances $L_3$ and $L_4$ are able to magnetically couple with both of the inductances $L_1$ and $L_2$. The input signal lines 2, 6, and 7 are supplied with input currents $I_A$, $I_B$, and $I_C$, respectively. Assume that the logic values of the input currents $I_A$, $I_B$, and $I_C$ are A, B, and C, respectively. By selecting appropriate values for the bias current $I_b$ and the input currents $I_A$, $I_B$ and $I_C$, the inductances $L_3$ and $L_7$ opposite to the inductance $L_1$ in the loop $I_2$ can produce a logic sum $(A+B)$, the inductances $L_4$ and $L_8$ opposite to the inductance $L_2$ in the loop $I_3$ can produce a logic sum $(A+C)$, and the loops $I_2$ and $I_3$ can produce a logic product $(A+B)(A+C)$. Thus, a logic output

$$(A+B)(A+C) = A(A+B+C) + B \cdot C = A + B \cdot C$$

can be obtained across the output terminals 4 and 5. That is, when the input current $I_A$ is supplied to the input signal line 2 or when the input currents $I_B$ and $I_C$ are supplied to the input signal lines 6 and 7, respectively, or when both of the above situations exist, the gate of Figure 5 assumes a voltage state.

From the foregoing description, it will be apparent that, according to the present invention, since input signal lines are arranged separately so as to be opposite to the inductances in respective superconductive loops, in a Josephson-junction logic gate consisting of multi-junction SQUIDs, in order to switch the gate from a superconducting state to a voltage state, a large input current is necessary as compared with the prior art. Therefore, the effect of an expanded allowable range of the input currents for maintaining the gate in a superconducting state can be obtained. Accordingly, the margin of operation of the Josephson-junction logic gate is improved. Also, since this effect is realized by magnetically coupled-type logic devices, no circuit for isolating the inputs from the output is necessary.

**Claims**

1. A Josephson-junction logic device comprising:

a first superconductive loop ($l_2$), having a first Josephson-junction element ($J_1$) and a second Josephson-junction element ($J_2$) and a first inductance ($L_1$) connected between the said first Josephson-junction element and the said second Josephson-junction element;

a second superconductive loop ($l_3$), having the said second Josephson-junction element ($J_2$) and a third Josephson-junction element ($J_3$) and a second inductance ($L_2$) connected between the said second Josephson-junction element and the said third Josephson-junction element;

first and second logic input signal lines (6, 7); and

output terminals (4, 5), connected for providing a logic output signal from across one of the said Josephson-junction elements when the device is in use;

characterised in that the said first logic input signal line (6) includes a third inductance ($L_7$) arranged adjacent to the said first inductance ($L_1$) so that magnetic coupling occurs between the third and first inductances but substantially no such coupling occurs between the third and second inductances, when the device is in use, and the said second logic input signal line (7) includes a fourth inductance ($L_8$) arranged adjacent to the said second inductance ($L_2$) so that magnetic coupling occurs between the fourth and second inductances but substantially no such coupling occurs between the fourth and first inductances when the device is in use.

2. A Josephson-junction logic device as set forth in Claim 1 further comprising a bias line (8) for supplying bias current to said superconductive loops ($l_2$, $l_3$), said bias line being connected to a point between said first inductance ($L_1$) and said second inductance ($L_2$).

3. A Josephson-junction logic device as set forth in Claim 1 further comprising a first bias line (9) for supplying a bias current to said first superconductive loop ($l_2$), said first bias line being connected to a middle point of said first inductance ($L_1$), and a second bias line (10) for supplying a bias current to said second superconductive loop ($l_3$), said second bias line being connected to a middle portion of said second inductance ($L_2$).

**Patentansprüche**

1. Logische Schaltung mit einer Josephson-Verbindung, mit:

einer ersten supraleitenden Schleife ($l_2$), die ein erstes Josephson-Verbindungs-Element ($J_1$) und

ein zweites Josephson-Verbindungs-Elements ($J_2$) und eine erste Induktanz ($L_1$) hat, welche zwischen dem genannten ersten Josephson-Verbindungs-Element und dem genannten zweiten Josephson-Verbindungs-Element angeschlossen ist;

einer zweiten supraleitenden Schleife ($l_3$), die das genannte zweite Josephson-Verbindungs-Element ($J_2$) und ein drittes Josephson-Verbindungs-Element ($J_3$) und eine zweite Induktanz ($L_2$) umfaßt, welche zwischen dem genannten zweiten Josephson-Verbindungs-Element und dem genannten dritten Josephson-Verbindungs-Element angeschlossen ist;

ersten und zweiten Leitungen (6, 7) für die logischen Eingangssignale und

Ausgangsanschlüssen (4, 5), die angeschlossen sind, um ein logisches Ausgangssignal quer über einem der Josephson-Verbindungs-Elemente zu erhalten, wenn die Vorrichtung in Betrieb ist,

dadurch gekennzeichnet, daß die genannte erste Leitung (6) für das erste logische Eingangssignal eine dritte Induktanz ($L_7$) umfaßt, die neben der genannten ersten Induktanz ($L_1$) so angeordnet ist, daß eine magnetische Kopplung zwischen der dritten und der ersten Induktanz auftritt, jedoch im wesentlichen keine solche Kopplung zwischen der dritten und der zweiten Induktanz auftritt, wenn die Vorrichtung in Betrieb ist, und die genannte Leitung (7) für das zweite logische Eingangssignal eine vierte Induktanz ($L_8$) umfaßt, die neben der genannten zweiten Induktanz ($L_2$) so angeordnet ist, daß eine magnetische Kopplung zwischen der vierten und der zweiten Induktanz eintritt, daß jedoch im wesentlichen keine solche Kopplung zwischen der vierten und der ersten Induktanz eintritt, wenn die Vorrichtung in Betrieb ist.

2. Logische Schaltung mit Josephson-Verbindung nach Anspruch 1, ferner mit einer Vorspannungsleitung (8) zur Zuführung eines Vorspannungsstromes zu den genannten supraleitenden Schleifen ($l_2$, $l_3$), welche Vorspannungsleitung mit einem Punkt zwischen der genannten ersten Induktanz ($L_1$) und der genannten zweiten Induktanz ($L_2$) verbunden ist.

3. Logische Schaltung mit Josephson-Verbindung nach Anspruch 1, ferner mit einer ersten Vorspannungsleitung (9) zur Zuführung eines Vorspannungsstromes zu der genannten ersten supraleitenden Schleife ($l_2$), welche Vorspannungsleitung mit einem mittleren Punkte der genannten ersten Induktanz ($L_1$) verbunden ist, und einer zweiten Vorspannungsleitung (10) zur Zuführung eines Vorspannungsstromes zu der zweiten supraleitenden Schleife ($l_3$), welche zweite Vorspannungsleitung mit einem mittleren Abschnitt der genannten zweiten Induktanz ($L_2$) verbunden ist.

**Revendications**

1. Dispositif logique à jonctions Josephson, comprenant:

une première boucle supraconductrice ($l_2$), possédant un premier élément à jonction Josephson ($J_1$) et un deuxième élément à jonction Josephson ($J_2$), ainsi qu'une première inductance ($L_1$) connectée entre ledit premier élément à jonction Josephson et ledit deuxième élément à jonction Josephson;

une deuxième boucle supraconductrice ($l_3$), possédant le deuxième élément à jonction Josephson ($J_2$) et un troisième élément à jonction Josephson ($J_3$), ainsi qu'une deuxième inductance ($L_2$) connectée entre ledit deuxième élément à jonction Josephson et ledit troisième à jonction Josephson;

une première et une deuxième ligne (6, 7) de signaux d'entrée logiques; et

des bornes de sortie (4, 5) connectées de façon à fournir un signal de sortie logique d'entre les bornes d'un desdits éléments à jonction Josephson lorsque le dispositif est en service;

caractérisé en ce que ladite première ligne (6) de signaux d'entrée logiques comporte une troisième inductance ($L_7$) disposée au voisinage de ladite première inductance ($L_1$) de façon qu'un couplage magnétique se produise entre les troisième et première inductances, tandis qu'il n'y a sensiblement aucun semblable couplage entre les troisième et deuxième inductances, lorsque le dispositif est en service, et ladite deuxième ligne (7) de signaux d'entrée logiques comporte une quatrième inductance ($L_8$) disposée au voisinage de ladite deuxième inductance ($L_2$) de façon qu'un couplage magnétique se produise entre les quatrième et deuxième inductances, tandis qu'il n'y a sensiblement aucun semblable couplage entre les quatrième et première inductances lorsque le dispositif est en service.

2. Dispositif logique à jonctions Josephson selon la revendication 1, comprenant en outre une ligne de polarisation (8) servant à délivrer un courant de polarisation auxdites boucles supraconductrices ($l_2$, $l_3$), ladite ligne de polarisation étant connectée en un point situé entre ladite première inductance ($L_1$) et ladite deuxième inductance ($L_2$).

3. Dispositif logique à jonctions Josephson selon la revendication 1, comprenant en outre une première ligne de polarisation (9) servant à délivrer un courant de polarisation à ladite première boucle supraconductice ($l_2$), ladite première ligne de polarisation étant connectée en un point médian de ladite première inductance ($L_1$), et une deuxième ligne de polarisation (10) servant à délivrer un courant de polarisation à ladite deuxième boucle supraconductrice ($l_3$), ladite deuxième ligne de polarisation étant connectée à la partie médiane de ladite deuxième inductance ($L_2$).

# Fig. IA

# Fig. IB

# Fig. IC

## Fig. 2A

## Fig. 2B

## Fig. 2C

## Fig. 3A

## Fig. 3B

# Fig.3C

# Fig. 3D

# Fig. 4

# Fig. 5